# EUROPEAN PATENT APPLICATION

(11) **EP 4 557 318 A1**
(43) Date of publication of application: **21.05.2025**
(21) Application number: 23210184.0
(22) Date of filing: 15.11.2023
(51) Int. Cl.: H01C 1/14, H01C 3/10, H01C 7/22, H01C 3/12, H01C 13/02, G01R 15/04, H01C 3/20, H01C 1/148

(54) **RESISTOR STRUCTURE AND A VOLTAGE DIVIDER ARRANGEMENT**

(71) Applicant: ABB SCHWEIZ AG, 5400 Baden (CH)
(72) Inventor: HOZOI, Adrian, 68219 Mannheim (DE); SOMMER, Felix, 64285 Darmstadt (DE); MIGUNOV, Vadim, 68526 Ladenburg (DE); PODZEMNY, Jaromir, 621 00 Brno (CZ)
(74) Representative: Maiwald GmbH

(57) **Abstract**

The invention relates to a resistor structure comprising at least an electrically insulating substrate, at least one electrically conductive terminal directly or indirectly provided on the substrate and having a terminal resistivity, at least one resistive trace forming part of a resistive path, the resistive trace directly or indirectly and at least partially provided on the substrate and joined to the terminal and having a trace resistivity, characterized in that at least a portion of the terminal and a portion of the resistive trace are indirectly joined via a junction section having a junction resistivity, wherein the junction resistivity is smaller than the trace resistivity.

## Description

### Field of the invention

The present invention concerns a resistor structure and a voltage divider arrangement as well as electric devices comprising such resistor structure and/or voltage divider arrangement.

### Background

Resistor structures and voltage divider arrangements are configured for high voltage applications, for example between 500 V and 1000 kV. Resistors which are employed at high voltages feature a high resistance to limit power dissipation, e.g. larger than 100 kΩ.

Resistor structures may comprise an electrically insulating substrate, at least one electrically conductive terminal applied on the substrate, and at least one resistive path comprising at least one resistive trace and applied on the substrate and joined to the terminal.

A voltage divider arrangement may, in its simplest embodiment, comprise two resistor structures electrically connected in series for transforming a high voltage, so-called primary voltage, to a lower voltage, so-called secondary voltage. The secondary voltage is significantly smaller than the primary voltage, e.g. by a voltage divider ratio between 10 to 100 000. In more complex embodiments of a voltage divider, one or both of the serial resistor structures may be replaced by resistive networks. The resistors or corresponding resistor networks may be referred to as high and low ohmic resistors, respectively.

These devices may be integrated in electrical devices, in which in particular severe operating conditions such as strong voltage overloads, power overloads, temperature variations, humidity variations, mechanical stresses and shocks may occur. Example electric devices are electronic instrument transformers (sensors), such as the KEVCD and KEVA sensor types of ABB, which are commonly employed in electrical power systems with a rated primary voltage between 7.2 kV and 48 kV.

US 9, 299, 484 B2, the contents of which is incorporated, discloses a resistive structure as well as a resistive voltage divider arrangement.

High voltage applications typically require particular engineering efforts, to ensure both functionality and safety. The reason is that such resistor structures are exposed to a high electric field intensity, typically imposing excessive electric stresses. This may result in dielectric failures, like partial discharge or electrical breakdown.

Therefore, it is desired to improve resistor structures and voltage divider arrangements as to manufacture, reliability and safety.

### Summary

The invention provides a resistor structure comprising at least one electrically insulating substrate, at least one, preferably two electrically conductive terminals directly or indirectly provided on the substrate and having a terminal resistivity, at least one resistive trace forming part of a resistive path, wherein the resistive trace is (optionally in parts) directly or indirectly provided on the substrate and joined to the terminal and has a trace resistivity, wherein at least a portion of the terminal and a portion of the resistive trace are indirectly joined via a junction section having a junction section resistivity, wherein the junction section resistivity is smaller than the trace resistivity.

By providing a junction section between the terminal and the resistive trace of the resistive path, direct contact between the terminal and the resistive trace is avoided. Instead of a single, direct joint between the terminal and the resistive trace, two joints are present. More specifically, a first joint is between the terminal and the junction section, and a second joint is between the junction section and the resistive trace. This may be seen as an indirect connection between the terminal and the resistive trace, namely via the junction section. The junction section may be seen as an intermediate entity between the terminal and the resistive trace.

In case of a direct joint between the electrically conductive terminal and the resistive trace, metal migration/diffusion from the electrically conductive terminal into the resistive trace may occur during firing during manufacture or during operation of the resistor structure at high voltage. Such metal migration into the resistive trace may alter the value of the electrical resistance of the resistive path. This, however, would alter the characteristics of the resistive path and, hence, impair the reliability of the resistor structure. More specifically, migration of metal atoms into the resistive trace /path may degrade the resistivity and thus the resistance of the resistive trace/path and/or its temperature coefficient of resistance.

By providing a junction section between the terminal and the resistive trace/path, and, hence, a direct connection of the electrically conductive terminal only to the junction section and not to the resistive trace, there is no direct metal migration/diffusion from the terminal into the resistive trace. Metal migration may mainly happens into the junction section and may have a limited reach, at least a reduced reach, into the resistive trace. Accordingly, metal migration from the electrically conductive terminal into the into the resistive trace is at least reduced as compared to a direct connection. Undesired changes of the electrical characteristics of the resistive trace/path are thus at least reduced. As the junction section has a smaller resistivity than the resistive trace, the resistivity of the junction section is closer to the resistivity of the electrically conductive terminal than the resistivity of the resistive trace to the resistivity of the electrically conductive terminal. This means that the difference as to the resistivity is reduced. Hence, the relative reduction of resistivity is lower when the junction section has a relatively low resistivity, at least a resistivity lower than that of the resistive trace/path. Accordingly, changes as to electrical characteristics caused by metal migration from the electrically conductive terminal into the junction section are of less relevance. For the manufacturing process, this may be advantageous in that it supports co-firing, namely firing various entities such as the terminals, the junction section and the resistive trace, in the same firing process. As firing processes are often costly and/or energy intensive, economic and environmental benefit may be achieved from reducing the number of firing cycles.

By providing a junction section resistivity smaller than the resitivity of the resistive trace/path, a resistance value of the junction section being smaller than a resistance value of the resistive path is preferably achieved. Accordingly, undesired changes of the resistance of the junction section, for example caused by metal migration into the junction section, have at most reduced impact on the total resistance of a resistor structure formed by the resitive path and one or more junction sections. This helps tolerating metal migration into the junction section and variations of electrical characteristics of the junction section while having reduced impact on the electrical characteristics of the resistor structure. This helps to manufacture efficiently a resistor structure with improved accuracy and stability.

As compared to the terminal, the junction section may be made of a material which is better matched to the material of the resistive trace, for example having more similar physical properties (like resistivity or coefficient of thermal expansion) or composition. This may improve the interface between the junction section and the resistive trace. Hence, the resistor structure may be more robust and its resistivity is improved as to accuracy and stability. Accordingly, the accuracy and the voltage withstand of the resistor structure and of the corresponding voltage divider arrangement may be enhanced.

Resistive materials commonly employed in thick film technology are based on formulations mainly comprising glass, particles of conductive oxide ceramic such as ruthenium oxide, and possibly other additives such as metal particles. Thick film resistive materials or films have a resistivity (sheet resistance) usually comprised between 50 mΩ/square and 1 GΩ/square.

In the context of the invention, a resistive trace of the resistive path is made of a resistive material with resistivity preferably between 50 Ω/square and 100 MΩ/square, or preferably between 500 Ω/square and 10 MΩ/square. Non-exhaustive examples of possible resistive materials are the R8700 Series from Heraeus or the 2000 Series from DuPont.

Electrically conductive materials commonly employed in thick film technology are based on formulations comprising a major amount of metal particles like Ag, Pd, Au, Pt and possibly other additives. Conductive materials comprising a significant content of Ag are often employed because of its very high conductivity, relatively low cost, and excellent compatibility to soldering alloys being employed in the electronic industry. Thick film conductor materials or films have a resistivity usually comprised between 1 mΩ/square and 1 Ω/square. Non-exhaustive examples of possible conductive materials are the C2210 from Heraeus or the 7484 from DuPont.

An insulator material is seen as having a volume resistivity larger than 10⁷ Ω·cm.

Optionally, the junction section resistivity may be larger than the terminal resistivity. In this case, a gradual decrease of the resistivity from the resistive trace to the terminal may be achieved. This may further reduce undesired metal migration from the terminal or from the junction section into the resistive trace/path. This may allow to better match the physical properties or composition of the junction section to the resistive trace.

Optionally, the junction section may have a length of at least 0.1 mm, preferably at least 0.3 mm, more preferably at least 1 mm. This may more reliably avoid metal migration from the terminal to the resistive path. The length of the junction section may be the shortest distance between a resistive trace and the conductive terminal along the junction section. Therefore, the length may be regarded as a "shortest path length". The shortest path length may be seen as not including overlapping portions with the said trace, but as including overlapping portions with other resistive traces if other resistive traces are provided on the junction path

The junction section may be made of a resistive material comprising conductive oxide ceramic, glass, etc.

Optionally, the junction section resistivity may be at least 100 mΩ/square and preferably below 1000 Ω/square, more preferably being comprised between 0.5 Ω/square and 100 Ω/square. This may help balancing the desired effects previously described and support effective manufacturing..

Optionally, the junction section resistivity may be at least 10 or at least 100 times smaller than the trace resistivity. In some embodiments, the junction section resistivity may be at least 1000 or even 10000 times smaller than the trace resistivity. This may be a measure to almost eliminate metal migration into the resistive trace/path by increasing the length of the junction section.

Optionally, the resistance of the junction section is less than 10% the resistance of the resistive path. In some ebodiments, the resistance of the junction section may be between 0.1% and 10% the resistance of the resistive path. This may help to reduce the impact of metal migration on the resistor structure and also better matching between the materials of the junction section and of the resistive trace.

Optionally, the junction section may overlap at least partially the portion of the resistive trace. This may be beneficial for manufacturing resistive traces with improved reliability and reproducibility as no discontinuity of the resistive trace is provided at an overlap. The portion of the terminal may overlap at least partially the junction section. This helps to avoid a discontinuity of the junction section at an overlap.

Optionally, a the junction section may overlap at least partially the portion of the terminal. This may be beneficial in terms of manufacture, as this means that theterminal can be applied and fired before the junction section or the resistive trace is applied, allowing for example to fire the terminal at a higher temperature.

Optionally, the junction section may be a junction element connecting the portion of the terminal and optionally a beginning or end of the resistive trace/path. In this embodiment, metal migration between the resistive path and the terminal may be reduced.

Optionally, the junction section may, additionally or alternatively, be an interconnecting element connecting at least two resistive traces of the resistive path and the portion of the terminal. In this embodiment, metal migration between the resistive trace/path and the terminal may be reduced.

Optionally, the junction section may, additionally or alternatively, be an interconnecting path connecting at least an end of a resistive trace of a first resistive path and an end of a resistive trace of a second resistive path and the portion of the terminal, wherein the resistive path comprises at least the first and second resistive paths each having at least one resistive trace having an end. In this embodiment, metal migration between the resistive path and the terminal may be reduced.

Optionally, multiple junction sections may be provided. For example, the first, second and third terminals, and the resistive path may comprise first and second resistive paths. At least one junction section may be a junction element connecting a portion of the first terminal, and a beginning of a resistive trace of the first resistive path. Additionally or alternatively, at least one junction section may be an interconnecting path connecting a resistive trace of the first resistive path, a resistive trace of the second resistive path, and the second terminal. Additionally or alternatively, at least one junction section may be an interconnecting element connecting at least two beginnings of a resistive trace of the second resistive path and a portion of the third terminal. In this embodiment, metal migration between the resistive paths and the terminals may be reduced.

Optionally, the resistive path may consist of one resistive trace being applied as a continuous film of resistive material being shaped at least partly like a meander or like a helix, or may have any other preferred shape.

Optionally, the resistive path comprises resistive traces which are electrically connected in series by transition elements to form the resistive path. Resistive traces may, at least partially, run parallel to each other.

Optionally, the resistive path comprises resistive traces or parts of resistive traces which are electrically connected in parallel by junction sections to form the resistive path.

Optionally, the resistivity of a junction section is approximately the same as the resistivity of a transition element, where the junction section and the transition element are preferably made of a same material and are deposited in a same process step.

Optionally, the resistance of the junction section is less than 10% or preferably between 0.1% and 10% of the resistance of the resistive path.

Optionally, a junction section comprises first and a second junction sections, wherein a resistive trace comprises a resistive trace part connected between the first and second junction sections, where the length of the first junction section is larger than the length of the resistive trace part.

Resistor structures of the invention may be manufactured using thick film technology, e.g. screen printing or stencil printing or direct printing through a nozzle. Films of conductive material and of resistive material are sequentially deposited on an insulating substrate. Typically, a single layer of a single material is deposited, followed by a subsequent step such as drying or firing. For example, conductive film or a resistive film are fired at a very high temperature, between 600°C and 950°C.

The insulating substrate may be made of ceramic material, such as aluminum oxide or aluminum nitride. The insulating substrate may be in the form of a flat, planar sheet or, alternatively, in the form of a cylinder.

In addition to the first electrically conductive terminal, at least a second electrically conductive terminal may be typically provided in a resistive structure, wherein the resistive path connects to the first and second terminals. In a voltage divider, the high and low-ohmic resistors may share a terminal, so that a voltage divider arrangement may comprise at least first, second and third terminals.

The resistive path may comprise, in addition to the at least first resistive path, a second resistive path, wherein the paths are connected in series. A resistive path (or the resistive paths) may at least partially be in the form of a helix. Hence, the resistive path may at least partially run helically.

A coating made of an electrically insulating material may be provided. In some embodiments, the coating may be the outermost entity or layer. The coating may cover the entire resistive structure or partially. The coating may cover at least part of the resistive path and possibly part(s) of the terminal(s). A part of each terminal is preferably not covered by the coating in order to provide electrical connection(s) to the resistive structure. The coating may be a film and may be made of a thickness between 5 to 100 µm and/or between 3 to 30 µm. The coating film may have different thicknesses, optionally a first thickness being between 5 and 100 µm, and a second thickness being between 3 and 30 µm, where the first thickness is larger than the second thickness by at least 50% or at least 5 µm.

Optionally, a second coating, e.g. made of a polymer, may be applied on a first coating. The second coating may be thicker than the first coating.

A shunt may be provided. A shunt section is configured to shunt a distinct portion of a resistive trace to proportionally reduce its effective resistive length. This may mean that the length which is electrically effective (and, thus, determines the electrical resistance of the trace ) is shorter than the actual length of the trace. A transition element or a junction section may act as shunt section. A shunt section has a lower resistivity than the resistive trace to which the shunt section (e.g. transition element) is connected to.

Optionally, the resistor structure comprises resistive traces being mainly identical and being preferably arranged periodically with mainly a same pitch. The resistive traces may be made of a same resistive material, and may have mainly a same thickness, width, slope, and (actual) length. This helps for efficient and reproducible manufacturing of the resistive traces and of the resistive path.

A voltage divider arrangement of the invention may comprise a high ohmic resistor and a low ohmic resistor electrically connected in series, where the voltage divider arrangement comprises at least one resistor structure of the invention. The high ohmic resistor is made of one or more resistive traces and the low ohmic resistor is made of one or more resistive traces, and the high ohmic and the low ohmic resistors differ as to their resistance.

Optionally, the voltage divider arrangement is provided on the same substrate and comprises resistive traces being substantially identical. This may provide an arrangement which is more effective to manufacture and more stable.

An electrical device of the invention comprises a resistor structure or a voltage divider arrangement of the invention.

### Brief description of the drawings

Figure 1 shows cross-sectional views of a resistive structure of the invention, wherein figures 1 (a), 1(b) and 1(c) refer to different embodiments.
Figure 2 shows a voltage divider arrangement of the invention, on a planar substrate in a top view.
Figure 3 shows perspective views of a voltage divider arrangement of the invention, on a cylindrical substrate. Figures 3(a) and 3(b) show views from different angles.
Figure 4 shows perspective views of a voltage divider arrangement of the invention, on a cylindrical substrate. Figures 4(a) and 4(b) show views from different angles.

### Detailed description of embodiments

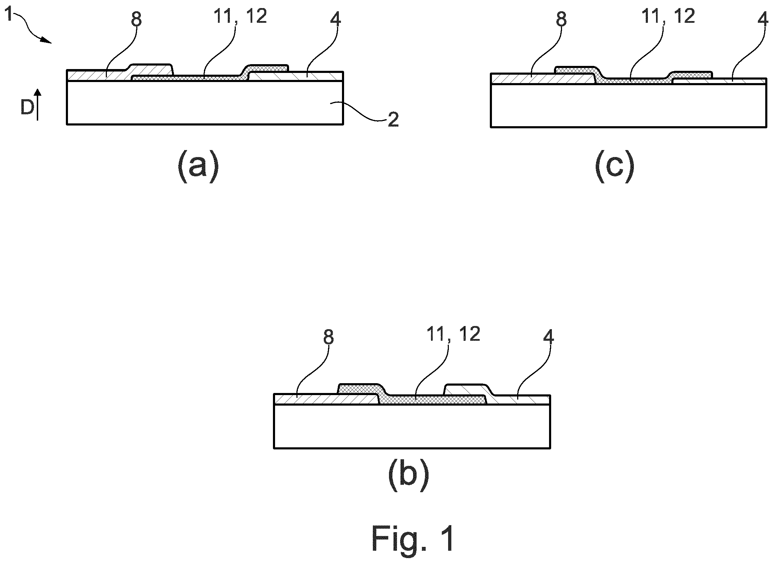

Figure 1 shows a resistor structure 1 comprising at least an electrically insulating substrate 2 as basis of the resistor structure 1, at least one electrically conductive terminal 4 directly provided on (top of) the substrate 2. In another embodiment, the terminal 4 may be indirectly on the substrate 2, which means that between the terminal 4 and the substrate 2, one or more other layers may be present. The terminal has a terminal resistivity Rₜ. At least one resistive trace 8 is provided, which is part of the resistive path 3. The resistive trace 8 is, in figure 1, directly provided on (top of) the substrate 2, at least partially on the substrate 2. In another embodiment, the resistive trace 8 may be indirectly on the substrate 2, which means that between the resistive trace 8 and the substrate 2, one or more other layers may be present. The resistive trace 8 has a resistivity Rₚ. At least a portion of the terminal 4 and a portion of the resistive trace 8 are indirectly joined via a junction section 11 having a junction resistivity Rⱼ. When viewed in the thickness direction D, the substrate 2 is the lowest layer, wherein the terminal 4, the resistive path 3 including the resistive trace 8 and junction section 11 can be seen as upper layers.

In figure 1, the junction section 11 is a junction element 12, which connects the portion of the terminal 4 and a beginning or end of the resistive trace 8. More specifically, as shown in figure 1(a), a portion of the resistive trace 8 may overlap the junction section 11 at least partially. This means that a part of the junction section 11 may be below the resistive trace 8, when viewed in the thickness direction D. As shown in figure 1(c), a part of the junction section 11 may overlap a portion of the terminal 4. In other words, the junction section 11 may in part be on top of the portion of the terminal 4. Figure 1(b) shows an embodiment in which the junction section 11 overlaps the resistive trace 8, and the terminal 4 overlaps the junction section 11.

The junction resistivity Rⱼ is smaller than the trace resistivity Rₚ. At the same time, the junction resistivity Rⱼ is larger than the terminal resistivity Rₜ. If the junction resistivity Rⱼ is larger than the terminal resistivity Rₜ, the resistivity of the entities shown in figure 1 decreases from left to right, i.e. from the trace resistivity to the terminal resistivity. In the embodiment as shown, the junction resistivity Rⱼ is at least 500 times smaller than the trace resistivity Rₚ. In absolute terms, the junction resistivity is at least 100 mΩ/square.

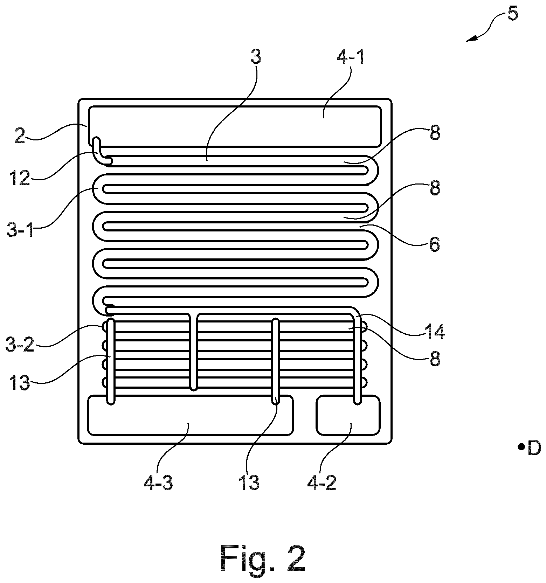

Figure 2 is a top view of a voltage divider arrangement 5 comprising two resistor structures 1 of the invention on a planar substrate 2. In addition to a junction element 12 representing a junction section 11 of the invention, two further embodiments of the junction section 11 are shown: Figure 2 shows a junction section 11 embodied as interconnecting element 13 and a junction section 11 embodied as interconnecting path 14. The interconnecting element 13 connects at least two resistive traces 8, in figure 2 four resistive traces, and the portion of the terminal 4. The interconnecting path 14 connect at least an end of a resistive trace 8 of a first resistive path 3-1 and an end of a resistive trace 8 of a second resistive path 3-2 and a portion of the second terminal 4-2. The resistive path 3, in this embodiment, comprises the first 3-1 and second 3-2 resistive paths, each having at least one resistive trace 8 having an end. The junction element 12 connects the first terminal 4-1 and a resistive trace 8 of the first resistive path 3-1. Figure 2 further shows the substrate 2 and gaps 6 between subsequent resistive traces 8. Any of the junction sections 11, embodied as junction element 12, interconnecting element 13 or interconnecting path 14, is longer than 0.1 mm.

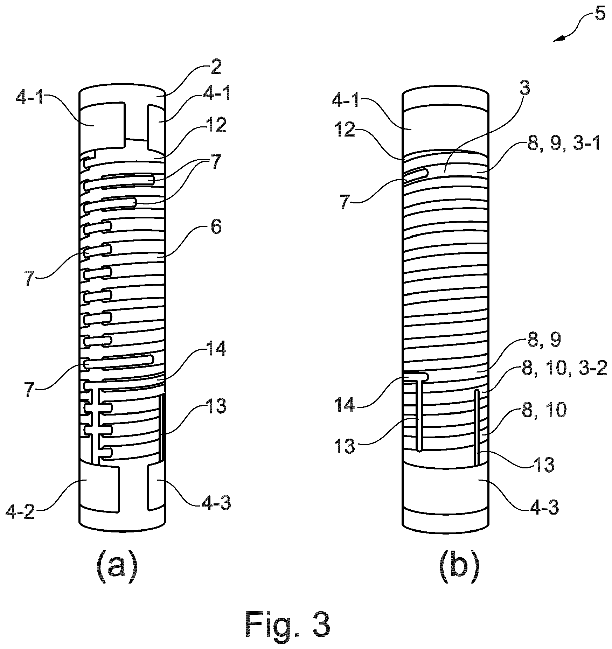

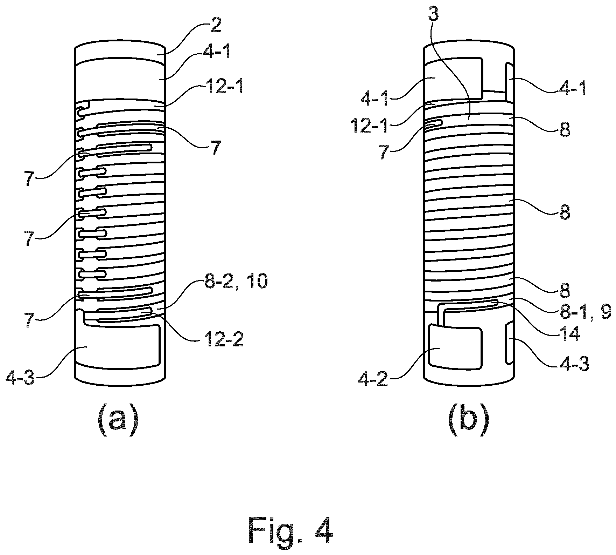

Figure 3 shows a voltage divider arrangement 5 allowing for transformation of voltage in a cylindrical form. The resistive path 3 comprises first and second resistive paths 3-1 and 3-2, and the resistive traces 8 are in the form of a helix. The voltage divider arrangement 5 comprises a first resistor structure of the invention as well as a second resistor structure of the invention. The first and second resistor structures are connected in series and differ as to their resistance. More specifically, from the different angles represented by the views of Figures 3(a) and 3(b), a high-ohmic resistor 9 representing a first resistor structure of the invention and a low-ohmic resistor 10 representing a second resistor structure of the invention are evident. The high-ohmic resistor 9 comprises resistive traces 8 connected by transition elements 7, forming the first resistive path 3-1. As shown, one transition element 7 connects two resistive traces 8. The low-ohmic resistor 10 also comprises resistive traces 8 connected by transition elements 7, forming the second resistive path 3-2, and further comprises an interconnecting element 13 and an interconnecting path 14, the second terminal 4-2 and the third terminal 4-3, respectively. The interconnecting path 14 may be provided without transition elements 7. An interconnecting path may also be connected in the middle of a trace like in Fig. 4, but also in variations of arrangements like in Fig. 3.

Figures 4(a) and 4(b) show one resistive trace 8 having a trace segment 8-2 in the low-ohmic resistor 10 as well as a trace segment 8-1 in the high-ohmic resistor 9. Thereby, the high-ohmic 9 and low-ohmic 10 resistors both comprise a rational number of resistive traces 8 such that the divider ratio can be finely configured. This is possible due to an interconnecting path 14 including a so-called shunting section. More speficially, Fig. 4 shows a voltage divider arrangement 5, where a first trace segment 8-1 of a resistive trace 8 is comprised in the high-ohmic resistor 9, and a second trace segment 8-2 of the same resistive trace 8 is comprised in the low-ohmic resistor 10. The trace segment 8-2 in the low-ohmic resistor 10 is connected to the third terminal 4-3 via a second junction element 12-2 looking like a transition element 7. The second junction element 12-2 is provided with a shunting section and the interconnecting path 14 is provided with a shunting section to reduce by a significant amount the effective resistive length of a resistive trace 8 at the second end of the resistive path 3 at the second 4-2 and third 4-3 terminals. A transition element 7 is provided with a shunting section to reduce by a lower amount the effective resistive length of a next resistive trace 8 near the second end of the resistive path 3 . Two transition elements 7 are each provided with a respective shunting section to reduce the effective resistive lengths of two respective resistive traces 8 at the first end of the resistive path 3 . A first junction element 12-1 is provided at the first end of the resistive path 3 at the first terminal 4-1.

In each of Fig. 2, 3 and 4, the junction element 12 comprises first and a second junction sections 12-1, 12-2, wherein a resistive trace 8 comprises a resistive trace part connected between the first and second junction sections 12-1, 12-2, where the length of the first junction section is larger than the length of the resistive trace part.

### Reference signs

1 resistor/resistive structure
2 electrically insulating substrate
3 resistive path
3-1 first resistive path
3-2 second resistive path
4 terminal
4-1 first terminal
4-2 second terminal
4-3 third terminal
5 voltage divider arrangement
6 gap
7 transition element
8 resistive trace
8-1 first trace segment
8-2 second trace segment
9 high-ohmic resistor
10 low-ohmic resistor
11 junction section
12 junction element
12-1 first junction element
12-2 second junction element
13 interconnecting element
14 interconnecting path
Rₚ resistivity of resistive trace of path
Rₜ resistivity of terminal
Rⱼ resistivity of junction section
D thickness direction

## Claims

1. Resistor structure (1) comprising at least
an electrically insulating substrate (2),
at least one electrically conductive terminal (4) directly or indirectly provided on the substrate (2) and having a terminal resistivity (Rₜ),
at least one resistive trace (8) forming part of a resistive path (3), the resistive trace (8) directly or indirectly and at least partially provided on the substrate (2) and joined to the terminal (4) and having a trace resistivity (Rₚ),
**characterized in that**
at least a portion of the terminal (4) and a portion of the resistive trace (8) are indirectly joined via a junction section (11) having a junction resistivity (Rⱼ), wherein the junction resistivity (Rⱼ) is smaller than the trace resistivity (Rp).

2. Resistor structure of claim 1, wherein the junction resistivity (Rⱼ) is larger than the terminal resistivity (Rₜ).

3. Resistor structure of any of the preceding claims, wherein the junction section (11) has a length of at least 0.1 mm, preferably at least 0.3 mm, more preferably at least 1 mm.

4. Resistor structure of any of the preceding claims, wherein the junction section resistivity (Rj) is at least 100 mΩ/square and preferably below 1000 Ω/square, more preferably being between 0.5 Ω/square and 100 Ω/square.

5. Resistor structure of any of the preceding claims, wherein the junction section resistivity (Rⱼ) is at least 10 or at least 100 times smaller than the trace resistivity (Rₚ).

6. Resistor structure of any of the preceding claims, wherein the the junction section (11) at least partially overlap the portion of the resistive trace (8) and/or the portion of the terminal overlaps at least partially the junction section (11).

7. Resistor structure of any of the preceding claims, wherein the junction section (11) is a junction element (12) connecting the portion of the terminal (4-1) and a beginning or end of the resistive trace (8).

8. Resistor structure of any of the preceding claims, wherein the junction section (11) is an interconnecting element (13) connecting at least two resistive traces (8) of the resistive path (3) and the portion of the terminal (4-3).

9. Resistor structure of any of the preceding claims, wherein the junction section (11) is an interconnecting path (14) connecting at least an end of a resistive trace (8) of a first resistive path (3-1) and a resistive trace (8) of a second resistive path (3-2) and the portion of the terminal (4-2), wherein the resistive path (3) comprises at least the first (3-1) and second (3-2) resistive paths each having at least one resistive trace (8) having an end.

10. Resistor structure of claims 7 to 9, wherein multiple junction sections (11) are provided and first (4-1), second (4-2) and third (4-3) terminals, and the resistive path (3) comprises first (3-1) and second (3-2) resistive paths,
wherein
at least one junction section (11) is a junction element (12) connecting a portion of the first terminal (4-1), and a beginning of a resistive trace (8) of the first resistive path (3-1),
and/or
at least one junction section (11) is an interconnecting path (14) connecting a resistive trace (8) of the first resistive path (3-1), a resistive trace (8) of the second resistive path (3-2) and the second terminal (4-2),
and/or
at least one junction section (11) is an interconnecting element (13) connecting at least two resistive trace (8) of the second resistive path (3-2) and a portion of the third terminal (4-3).

11. Voltage divider arrangement (5) for electrical power systems for transformation of voltage, the voltage divider arrangement comprising a first resistor structure (1) of any of the preceding claims, and a second resistor structure (1), optionally of any of the preceding claims, wherein the first and second resistor structures are connected in series and the first and second resistor structures differ as to their resistance.

12. Electrical device comprising the resistor structure (1) and/or the voltage divider arrangement (5) of any of the preceding claims.
